Europäisches Patentamt

**European Patent Office**

**Office européen des brevets**

(11) Numéro de publication: **0 280 381 B1**

(12) **FASCICULE DE BREVET EUROPEEN**

(45) Date de publication de fascicule du brevet:
**15.01.92**

(51) Int. Cl.5: **H04M 9/08**, H03G 3/20

(21) Numéro de dépôt: **88200355.1**

(22) Date de dépôt: **25.02.88**

(54) **Circuit de commande de gain d'un amplificateur d'écoute par haut-parleur pour la suppression de l'effet Larsen.**

(30) Priorité: **27.02.87 FR 8702660**

(43) Date de publication de la demande:
**31.08.88 Bulletin 88/35**

(45) Mention de la délivrance du brevet:
**15.01.92 Bulletin 92/03**

(84) Etats contractants désignés:
**DE FR GB IT SE**

(56) Documents cités:
**FR-A- 2 532 134**
**FR-A- 2 537 810**
**US-A- 4 507 524**
**US-A- 4 542 263**

(73) Titulaire: **PHILIPS COMPOSANTS**
**117, quai du Président Roosevelt**
**F-92130 Issy les Moulineaux(FR)**

(84) Etats contractants désignés:
**FR**

Titulaire: **N.V. Philips' Gloeilampenfabrieken**
**Groenewoudseweg 1**
**NL-5621 BA Eindhoven(NL)**

(84) Etats contractants désignés:
**DE GB IT SE**

(72) Inventeur: **Coulmance, Jean-Pierre Société**
**Civile S.P.I.D.**
**209, rue de l'Université**
**F-75007 Paris(FR)**

(74) Mandataire: **Pinchon, Pierre et al**
**Société Civile S.P.I.D. 156, Boulevard Haussmann**
**F-75008 Paris(FR)**

Rank Xerox (UK) Business Services

# Description

La présente invention concerne un circuit de commande de gain d'un amplificateur pour l'écoute par haut-parleur dans un appareil comportant par ailleurs un microphone et son amplificateur associé, notamment dans le but de supprimer l'effet Larsen, circuit consistant essentiellement en une boucle de contre-réaction réduisant le gain de l'amplificateur d'écoute par haut-parleur lorsque le signal provenant du microphone dépasse un seuil déterminé.

L'invention concerne également l'application de ce circuit de commande de gain à un poste téléphonique à écoute amplifiée par haut-parleur. Il est bien connu que dans tous les systèmes comportant à la fois un haut-parleur alimenté par son amplificateur ainsi qu'un microphone dont le signal est appliqué plus ou moins directement à l'amplificateur, il existe un risque d'oscillation par effet Larsen dû au couplage acoustique entre le haut-parleur et le microphone. C'est le cas par exemple d'un poste téléphonique muni d'une écoute amplifiée, cas auquel l'invention s'adresse plus particulièrement mais non exclusivement.

Dans un poste téléphonique à écoute amplifiée il est nécessaire de prévoir des moyens pour supprimer l'état d'oscillation Larsen et il est très souhaitable que cette suppression, par une forte réduction du gain de l'amplificateur du haut-parleur, interviennent de manière automatique, c'est-à-dire sans que l'utilisateur du poste ait à exercer une intervention quelconque.

Diverses solutions techniques ont déjà été proposées. D'une manière générale, on peut constater que ces solutions consistent à prévoir, d'une part, un circuit de détection de l'état d'oscillation due à l'effet Larsen fournissant à la sortie un signal de commande qui peut être du type tout ou rien, ou proportionnel, et d'autre part, un circuit de commande proprement dit qui agit sur un étage préamplificateur à gain variable et provoque une réduction, voire une annulation totale du gain lorsque le circuit de détection de l'effet Larsen a constaté un état d'oscillation.

Un exemple de poste téléphonique à écoute amplifiée et régulation de gain est fourni par le document FR-A-2 537 810.

Cependant, par principe, un tel montage est encore sujet à relaxation puisque, à la suite d'une oscillation, une première réduction de gain peut entraîner une disparition de cette oscillation tandis qu'un instant après, la commande de gain agissant dans le sens d'une augmentation apparaît alors une seconde oscillation, et ainsi de suite...

On comprend facilement qu'il n'existe pas une solution simple pour réaliser la fonction recherchée et ceci d'autant plus que le circuit de détection de l'effet Larsen doit être très sélectif pour distinguer un signal d'oscillation d'un signal audio de forte amplitude mais momentanné comme un bruit ambiant ou un choc sur le microphone.

L'invention vise à fournir un circuit de commande convenable du gain de l'amplificateur d'écoute par haut-parleur, évitant la relaxation et qui ferait appel à des circuits essentiellement intégrables.

Conformément à l'invention, ce but est atteint par un circuit de commande conforme au paragraphe préliminaire, caractérisé en ce que la boucle de contre-réaction comportant des premiers moyens de contrôle, commandant une réduction de gain de l'amplificateur d'écoute par haut parleur avec une première constante de temps, et le dit seuil prédéterminé étant un premier seuil, elle comporte encore des seconds moyens de contrôle comparant le signal provenant du microphone à un second seuil, plus faible que ledit premier seuil, qui commandent une réduction de gain avec une seconde constante de temps inférieure à la première, à partir du moment où le gain a été réduit en dessous d'une valeur de gain de référence par lesdits premiers moyens, alors qu'ils restent inactifs lorsque le gain reste supérieur à ladite valeur de référence.

En l'absence d'oscillation Larsen, lesdits premiers moyens de contrôle sont normalement suffisants pour atténuer convenablement l'amplification du signal d'écoute par haut-parleur, si cela est nécessaire, et d'assurer la régulation de l'amplification de la manière habituelle.

Tout signal acoustique qui parvient au microphone avec un fort niveau mais pour une durée brève, c'est-à-dire une durée inférieure à la première constante de temps, ne déclenche pas les seconds moyens, par opposition à l'instabilité provoquée par l'effet Larsen qui engendre, par couplage acoustique, un fort signal de microphone et pour une durée généralement importante dépendant des conditions de couplage acoustique entre le haut-parleur et le microphone. Dès que les premiers moyens de contrôle ont conduit à abaisser le gain en dessous de la valeur déterminée prise comme référence, ce qui se produit après la première constante de temps, les seconds moyens de contrôle entrent en action avec une constante de temps réglée nettement plus faible que la constante de temps des premiers moyens, et le gain est rapidement réduit à la valeur nécessaire pour que la régulation s'opère par comparaison avec le second seuil. Comme le second seuil est choisi de valeur inférieure au premier seuil, il ne se produit pas de relaxation et le circuit ne revient à des conditions normales de gain que lorsque le signal du microphone devient inférieur au second seuil, soit en pratique, lorsque la cause de l'oscillation a disparu.

Selon un mode de mise en oeuvre avantageux par sa simplicité, le circuit de commande de gain est caractérisé en ce que le gain de l'amplificateur d'écoute par haut parleur est commandé par la tension de charge d'un condensateur, chargé en permanence à travers une source de courant et en ce que les premiers et seconds moyens de contrôle ont leurs sorties qui provoquent la décharge de ce condensateur via respectivement une première et une seconde résistance de décharge, la première résistance de décharge ayant une valeur plus élevée que celle de la seconde résistance de décharge.

Selon ce mode de mise en oeuvre, le circuit de commande se caractérise en outre en ce que le condensateur est chargé à partir du potentiel le plus positif du circuit, en ce que lesdits premiers et seconds moyens de contrôle déchargent le condensateur par leur borne de sortie qui est du type à transistor NPN (ou MOS à canal N), à collecteur ouvert (ou drain ouvert), et en ce que la première résistance de décharge du condensateur est disposée en série avec la seconde résistance de décharge. Les transistors de ce type ont l'avantage d'être facilement intégrables.

L'utilisation de sorties du type à collecteur ouvert permet de pouvoir coupler les sorties des premières et seconds moyens de contrôle à travers leur résistance de décharge respective puisque l'état de haute impédance de la sortie de l'un des moyens de contrôle reste sans effet sur la sortie de l'autre.

Selon l'invention, une variante de ce mode de mise en oeuvre dispense de l'utilisation de résistances de décharge lorsque les premiers et seconds moyens de contrôle ont leur sortie qui travaille à courant de décharge limité à une valeur fixée ; le courant de sortie des premiers moyens est alors fixé à une valeur plus faible que la valeur du courant de sortie des seconds moyens, et les sorties en questions sont connectées en parallèle sur le condensateur.

Un mode particulier de mise en oeuvre de l'invention est caractérisé en ce que les premiers moyens de contrôle comportent un premier comparateur dont l'entrée positive reçoit le signal provenant du microphone après amplification, dont l'entrée négative est porté à une première tension de référence laquelle étant inférieure au niveau continu du signal provenant du microphone, définit par rapport à ce niveau ledit premier seuil, et dont la sortie constitue la sortie desdits premiers moyens de contrôle, en ce que les seconds moyens de contrôle comportent un deuxième, un troisième et un quatrième comparateur, tous à sortie du type à collecteur ouvert d'un transistor NPN, en ce que le deuxième comparateur a son entrée négative qui reçoit le signal provenant du microphone après amplification, et son entrée positive qui est portée à une deuxième tension de référence légèrement supérieure à la première tension de référence mais cependant inférieure au niveau continu du signal provenant du microphone et qui définit par rapport à ce niveau ledit second seuil, en ce que la sortie du deuxième comparateur est d'une part connectée au point intermédiaire d'un premier pont d'impédances lequel est connecté par ailleurs entre les tensions extrêmes du circuit et d'autre part connectée à l'entrée négative du troisième comparateur, en ce que le quatrième comparateur reçoit sur son entrée positive une tension sensiblement égale à la tension de charge du condensateur et a son entrée négative portée à une troisième tension de référence correspondant à la tension présentée par le condensateur pour ladite valeur de gain de référence, en ce que la sortie du quatrième comparateur est connectée au pied d'un deuxième pont d'impédances connecté en tête à la tension la plus positive et dont le point intermédiaire est connecté à l'entrée négative du troisième comparateur et fait apparaître, lorsque la sortie du quatrième comparateur est à l'état bas, une quatrième tension de référence qui est réglée à une valeur inférieure à la tension du point intermédiaire du premier pont d'impédances lorsque la sortie du deuxième comparateur est dans l'état de haute impédance, et en ce que la sortie du troisième comparateur constitue la sortie desdits deuxièmes moyens de contrôle.

A l'exception du condensateur dont la tension commande le gain de l'amplificateur d'écoute par haut-parleur, les éléments constituant le circuit de commande peuvent être intégrés ce qui conduit à un circuit particulièrement économique.

La description qui va suivre en regard des dessins annexés fera bien comprendre comment l'invention peut être réalisée, dessins dans lesquels :

- la figure 1 représente un schéma bloc du circuit de commande selon l'invention, appliqué à un poste téléphonique à écoute amplifiée,
- la figure 2 montre un schéma plus détaillé du circuit de commande selon l'invention, et
- la figure 3 donne un diagramme de tensions en fonction du temps en plusieurs points du circuit de la figure 2.

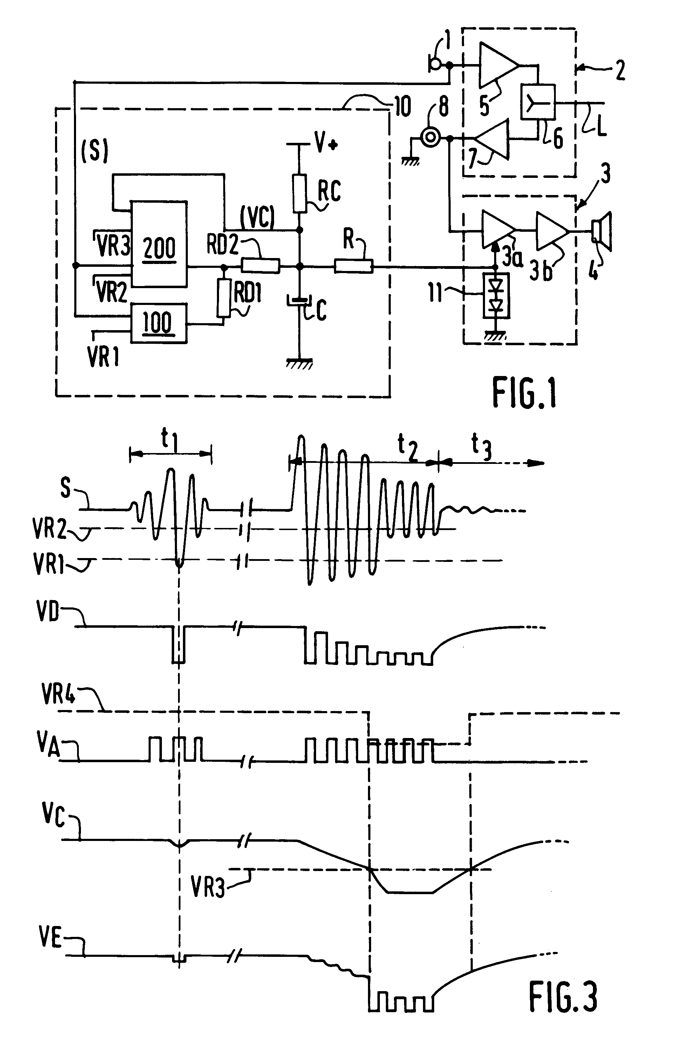

La figure 1 représente le schéma général d'un appareil comportant un microphone 1, une chaîne d'amplification et de traitement du signal 2 et 3, et un haut-parleur 4. Dans le cas particulier d'un poste téléphonique le bloc représenté en 2 comporte un préamplificateur 5 pour le signal du microphone, un module séparateur 6 encore appelé fonction hybride, raccordé à la ligne téléphonique L et un préamplificateur d'écoute 7 pour l'écouteur 8 du combiné. Le bloc représenté en 3 assure l'amplification du signal d'écoute en vue d'alimenter le haut-parleur 4 et comporte un étage préamplificateur 3a à gain commandable et un étage amplificateur de puissance 3b à gain fixe.

Selon les circonstances, un couplage acoustique peut se produire entre le haut parleur 4 et le microphone 1 qui est susceptible d'entraîner une instabilité connue sous le nom d'effet Larsen. En vue de suprimer cet effet indésirable ou d'en atténuer considérablement les conséquences il est prévu un circuit de commande de gain 10 de l'amplificateur d'écoute par haut-parleur contenu dans le bloc 3. Le circuit de commande de gain 10 se comporte globalement comme une boucle de contre- réaction. Son signal d'entrée S peut être prélevé en tout point de la chaîne d'amplification entre le microphone 1 et le haut parleur 4 mais de préférence il est prélevé sur le microphone 1 notamment dans le cas d'un poste téléphonique. Selon l'invention le signal S est appliqué après une éventuelle amplification à l'entrée de premiers moyens de contrôle 100 qui effectuent une comparaison du signal S avec une première tension de référence VR1.

Le circuit de commande de gain 10 comporte également un condensateur C dont une armature est reliée à la masse et l'autre est chargée à partir du potentiel positif V+ à travers une résistance de charge RC. La tension de charge VC de ce condensateur C peut être limitée si on le désire par un limiteur de tension 11 constitué par exemple par un certain nombre de jonctions semiconductrices en direct situation qui peut exister par construction à l'entrée de commande de gain de l'étage préamplificateur 3a. La tension VC sert à la commande de gain de l'amplificateur d'écoute 3 et peut être convertie en courant de commande au moyen d'une résistance R comme indiqué sur la figure. Le condensateur C peut être déchargé par la sortie des premiers moyens de contrôle 100 à travers une première résistance de décharge RD1 et une seconde résistance de décharge RD2 connectée en série. La tension de repos du signal S détermine par rapport à la première tension de référence VR1 un premier seuil qui lorsqu'il n'est pas franchit maintient la sortie des premiers moyens de contrôle 100 à l'état de haute impédance, la sortie de ces moyens étant du type à collecteur ouvert. Lorsque le premier seuil est franchi la sortie des premiers moyens de contrôle 100 passe à l'état bas et provoque la décharge du condensateur C à travers les résistances de décharge RD1 et RD2 selon une première constante de temps qui est égale à (RD1 + RD2) .C .

Le signal S est également appliqué à l'entrée de seconds moyens de contrôle 200 et ce signal est comparé à une deuxième tension de référence VR2 alors que la sortie de ces seconds moyens de contrôle 200 est connectée au point intermédiaire entre les résistances de décharge RD1 et RD2. La deuxième tension de référence VR2 est choisie telle qu'elle forme avec la tension de repos du signal S un second seuil inférieur audit premier seuil. Comme on le verra en détail ultérieurement, les seconds moyens de contrôle 200 sont également commandés à partir de la tension de charge VC du condensateur C, et la sortie de ces seconds moyens n'est activée que lorsque la tension VC est descendue en dessous d'une troisième tension de référence VR3 correspondant à la tension présentée par le condensateur C pour une valeur réduite de gain qui sert de référence. Ainsi les seconds moyens de contrôle 200 ne commandent une réduction du gain de l'amplificateur de puissance qu'à partir du moment ou les premiers moyens de contrôle 100 ont déjà réduit le gain en dessous de ladite valeur de référence. Dans ce cas, la sortie des seconds moyens de contrôle 200 qui est également du type à collecteur ouvert provoque une décharge du condensateur C à travers la résistance de décharge RD2 choisie de préférence de valeur très inférieure à la première résistance de décharge RD1 et donc selon une seconde constante de temps très inférieure à la première constante de temps des premiers moyens de contrôle 100. Si le signal S du microphone conserve une amplitude relativement élevée c'est-à-dire supérieure au second seuil déterminé par la deuxième tension de référence VR2, le gain de l'amplificateur d'écoute 3 se trouve régulé par les seconds moyens de contrôle 200.

Au contraire, lorsque l'amplidude du signal S redescend en dessous du second seuil, et donc à plus forte raison en dessous du premier seuil, les deux sorties des premiers et seconds moyens de contrôle sont à l'état de haute impédance et par conséquent le condensateur C se recharge à travers la résistance RC et le gain de l'amplificateur d'écoute 3 retourne à une valeur élevée nominale.

Dans ce qui précède, on a indiqué que différents seuils pour le fonctionnement des moyens de contrôle 100 et 200 sont obtenus par des tensions de référence VR1 à VR3. Il est clair cependant, qu'une solution équivalente est obtenue dans une variante de réalisation (non représentée), fonctionnant en courant et non pas en tension dans laquelle les seuils nécessaires au fonctionnement des moyens de contrôle 100 et 200 sont définis par des courants de valeur prédéterminée.

De manière analogue, une autre variante de réalisation (non représentée) concerne les résistances de décharge RD1 et RD2 qui peuvent être supprimées lorsque les sorties des moyens de contrôle 100 et 200 fonctionnent à courant fixé lorsqu'elles sont dans leur état conducteur.

Selon cette variante, on choisit alors une valeur de courant de sortie des premiers moyens de contrôle 100 qui est de préférence très inférieure à la valeur du courant de sortie des seconds moyens de contrôle 200.

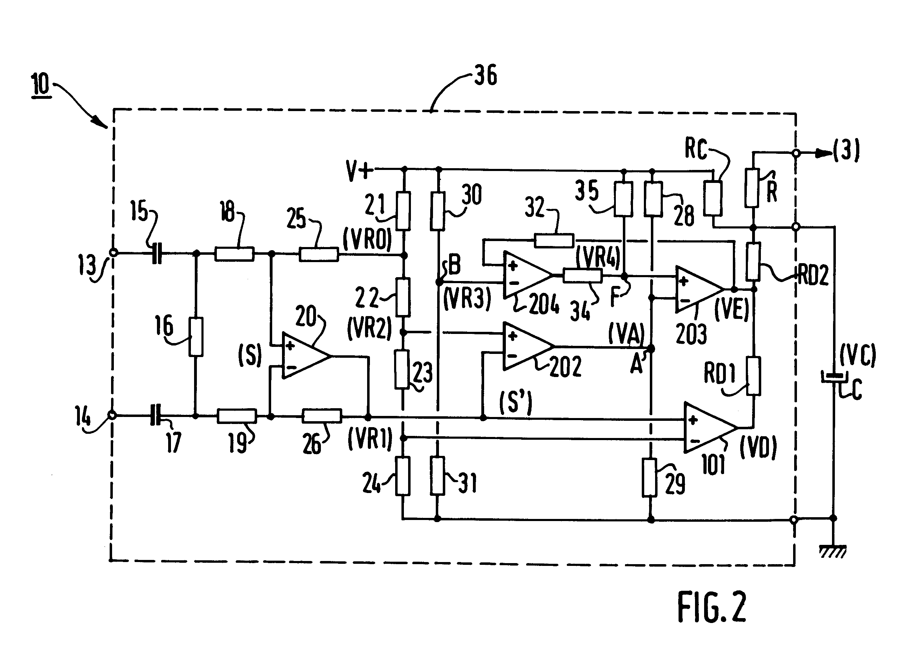

On se reporte maintenant à la figure 2 qui représente à titre d'exemple de mise en oeuvre un schéma plus détaillé du circuit de commande 10 de la figure 1.

Les deux bornes du microphone sont reliées aux deux bornes d'entrée 13 et 14 du circuit de commande 10. La référence continue du signal de microphone est tout d'abord éliminée par un filtre en pi constitué par l'association en série du condensateur 15 de la résistance 16 et du condensateur 17. Le signal de microphone ainsi filtré est appliqué via les résistances de protection 18 et 19 aux entrées d'un amplificateur différentiel 20.

Entre la tension positive d'alimentation V + et la tension de référence (masse) est disposée une chaîne de quatre résistances 21, 22, 23, 24, qui déterminent une première tension de référence VR1 au noeud entre les résistances 24 et 23, une deuxième tension de référence VR2 au noeud entre les résistances 23 et 22 et une tension de référence principale VR0 au noeud entre les résistances 22 et 21. La tension de référence principale VR0 est appliquée à l'entrée positive de l'amplificateur différentiel 20 à travers une résistance de protection 25 et l'entrée négative de cet amplificateur différentiel est rebouclée sur sa sortie via une résistance de contre-réaction 26.

En définitive, le signal qui est noté S' sur la figure et qui est le signal de microphone amplifié par l'amplificateur différentiel 20, a un niveau continu sensiblement égal à la tension de référence principale VR0. A titre d'exemple pratique, le gain de l'amplificateur différentiel 20 est établi au voisinage de 50 les tensions de référence VR0, VR1 et VR2 sont établies aux alentours de la moitié de la tension V + tandis que la tension de référence VR1 est inférieure à la tension de référence principale VR0 de 12 millivolts environ, différence qui constitue ledit premier seuil, et que la deuxième tension de référence VR2 est inférieure à la tension de référence principale VR0 de 1,5 millivolt, et constitue ledit second seuil qui est huit fois plus petit que le premier seuil.

Le signal S' provenant du microphone, après amplification, est appliqué à l'entrée positive d'un premier comparateur 101 à sortie collecteur ouvert et dont l'entrée négative reçoit la première tension de référence VR1. Le signal S' est également appliqué à l'entrée négative d'un deuxième comparateur 202 à sortie collecteur ouvert tandis que son entrée positive reçoit la deuxième tension de référence VR2. La sortie du comparateur 202 est connectée au point A intermédiaire d'un pont constitué par la résistance 28 connectée par ailleurs à la tension positive V + et par la résistance 29 connectée à la masse. Les valeurs des résistances 28 et 29 sont choisies de telle sorte que la tension VA du point A est légèrement supérieure à la moitié de la tension positive V +. Un troisième comparateur 203 à sortie collecteur ouvert a son entrée négative connectée au point A. Un quatrième comparateur 204 à sortie collecteur ouvert a son entrée négative porté à une troisième tension de référence VR3 portée par le point B intermédiaire d'un pont de résistance 30 et 31 qui sont connectées respectivement par ailleurs à la tension positive V + et à la masse. La troisième tension de référence VR3 correspond à la tension présentée par le condensateur C pour une certaine valeur de gain de référence en dessous duquel les seconds moyens de contrôle devront entrer en action, comme il sera expliqué ci-après. Conformément à ce qui a déjà été décrit à propos de la figure 1, le condensateur C est chargé en permanence à partir de la tension positive V + à travers la résistance de charge RC et éventuellement déchargé selon les circonstances à partir des sorties du premier comparateur 101 et du troisième comparateur 203 à travers respectivement les résistances de décharges RD1 et RD2 dont le branchement série est connecté au point de jonction entre la résistance de charge RC et le condensateur C. La sortie du troisième comparateur 203 qui lorsqu'elle est à haute impédance porte une tension sensiblement égale à la tension de charge du condensateur C est connectée via une résistance de protection 32 à l'entrée positive du quatrième comparateur 204. Enfin la sortie du quatrième comparateur 204 est connectée au pied d'un pont constitué des résistances 34 et 35 qui est connecté en tête à la tension positive V + et dont le point intermédiaire F fait apparaître une quatrième tension de référence VR4 qui, lorsque la sortie du quatrième comparateur 204 est à l'état bas, est réglée à une valeur inférieure à la tension VA du point A lorsque la sortie du deuxième comparateur 202 est à l'état de haute impédance. Le point F intermédiaire du pont de résistance 34 et 35 est connecté à l'entrée positive du troisième comparateur 203.

On va maintenant décrire à l'aide de la figure 3 le fonctionnement du circuit de commande de gain 10 de la figure 2. La figure 3 représente d'une part le signal S' provenant du microphone après amplification, par comparaison avec la première tension de référence VR1 et la deuxième tension de référence VR2, et d'autre part les signaux :
- VD en sortie du premier comparateur 101
- VA, tension du point A, par comparaison avec la tension VR4
- VC, tension de charge du condensateur C, par comparaison avec la tension VR3
- VE, tension à la sortie du troisième comparateur 203.

Il est à noter sur cette figure, que pour plus de commodité les signaux représentés sont à une échelle tout à fait arbitraire et non proportionnée. On a représenté une première période t1 durant laquelle le signal S' présente une amplitude passagèrement élevée qui est caractéristique du signal de parole. On rappelle que le signal de parole peut être caractérisé par un facteur de crête qui suit sensiblement la loi :

$$\theta = (w/Ln2)\, e^{-x\sqrt{3}/2}$$

où x représente le rapport entre la valeur absolue d'un seuil donné et la tension efficace du signal, et $\theta$ représente la somme des durées de dépassement de ce seuil rapportée au temps total d'observation. Le circuit de commande 10 tire parti de cette propriété caractéristique du signal vocal.

Durant cette période t1 le premier comparateur 101 a sa sortie qui passe à l'état bas lorsque la première tension de référence VR1 est franchie et influe progressivement à travers la résistance de décharge DR1 de valeur relativement élevée, sur la tension de charge VC du condensateur C. Pendant la même période la deuxième tension de référence VR2 est également franchie de sorte que le deuxième comparateur 202 a sa sortie qui présente un signal VA qui au repos est à l'état bas et présente des créneaux positifs pour les alternances correspondantes du signal S' cependant que le quatrième comparateur 204 n'ayant pas basculé la tension VR4 du point F se maintient au potentiel le plus élevé V +. Ainsi le troisième comparateur 203 ne bascule pas pendant cette période de temps t1.

On a représenté également à la figure 3 une autre période de temps t2 durant laquelle est supposée réalisée une condition de couplage acoustique telle que le système oscille tandis que pour la période de temps suivante t3 les conditions d'oscillation ont disparu. Durant un premier intervalle de temps correspondant à la première constante de temps de décharge dûe à l'action du premier comparateur 101 et de la première résistance de décharge RD1 le gain de l'amplificateur d'écoute 3 est progressivement réduit sous le seul effet du premier comparateur 101 et ceci jusqu'à ce que la tension de charge du condensateur VC tombe en dessous de la troisième tension de référence VR3. A cet instant, le quatrième comparateur 204 bascule et le point F fait apparaître une tension de référence VR4 inférieure au sommet des créneaux positifs du signal VA en sortie du comparateur 202. A partir de cet instant le troisième comparateur 203 est en mesure de basculer en réponse aux créneaux positifs de la sortie du deuxième comparateur 202 et induit sur sa sortie à l'état bas une décharge accélérée du condensateur C sous l'effet de la résistance de décharge RD2 choisie nettement inférieure à la résistance RD1. Le gain passe alors rapidement à une valeur très faible sous l'effet de la commande de tension du condensateur C et le circuit régule alors la valeur de ce gain en fonction des conditions et de l'amplitude du signal S' tant que celui-ci présente une amplitude telle que la deuxième tension de référence VR2 reste franchie par les alternances négatives de ce signal.

Durant la troisième période de temps t3 les conditions de couplage acoustique ayant été modifiées le signal S' est supposé réduit à une valeur faible telle qu'aucun des deux seuils ne soit dépassé. Les sorties des premiers comparateurs 101 et troisième comparateur 203 sont maintenant à l'état de haute impédances de sorte que le condensateur C se recharge à travers la résistance de charge RC. Lorsque la tension VC de charge du condensateur C dépasse le niveau de la troisième tension de référence VR3 présentée par le point B le quatrième comparateur 204 bascule à nouveau à l'état de haute impédance en sortie de sorte que la tension au point F remonte à la valeur de la tension positive V +. L'ensemble des comparateurs 202, 203 et 204 retourne à son point stable de fonctionnement en l'absence d'une amplitude élevée du signal S'.

On observe en définitive que le comparateur 101 jouant le rôle de premiers moyens de contrôle agit selon une première constante de temps déterminée principalement par la résistance de décharge RD1 tant que le signal S' reste d'une amplitude qui peut être régulée par les premiers moyens sans que le gain ne soit abaissé en dessous du gain de référence correspondant à la troisième tension de référence VR3.

Lorsque le signal du microphone est de forte amplitude (les deux seuils étant dépassés), le condensateur C se décharge selon ladite première constante de temps après quoi l'ensemble des comparateurs 202, 203 et 204 entrent en fonctionnement avec une constante de temps due à la résistance de décharge RD2 qui peut être choisie par exemple 20 fois inférieure à la résistance de décharge RD1 et cet ensemble de comparateurs constituant les seconds moyens de contrôle, régulent alors la décharge du condensateur et donc le gain de l'amplificateur d'écoute 3 tant que le signal S' conserve une amplitude qui dépasse le second seuil correspondant à la deuxième tension de référence VR2.

La partie du circuit 10 de la figure 2, qui est entourée d'un cadre 36 en tirets, peut être facilement intégrée sous forme de circuit monolithique. Pour faciliter cette opération, certaines résistances de valeur élevée peuvent être avantageusement remplacées par des éléments fonctionnellement équivalents. Ainsi, le premier pont d'impédance décrit comme étant constitué par les résistances 28 et 29 peut être, selon une variante non représentée sur la figure, constitué par l'association en série d'une source de courant connectée à la tension V+ et d'une impédance non linéaire connectée à la masse, cette impédance non linéaire étant formée d'une pluralité de jonctions semiconductrices en série qui fixe normalement la tension VA du point A. Il en va de même pour le deuxième pont d'impédance décrit comme formé des résistances 34 et 35 et encore pour celui formé par les résistances 30 et 31. De manière similaire la résistance 21 peut être remplacée par une source de courant et la résistance 24 par une série de jonctions semiconductrices en direct, tandis que les résistance 22 et 23, qui sont de plus faible valeur, peuvent être conservées.

Enfin, ainsi qu'il est connu en particulier des spécialistes qui effectuent l'intégration des fonctions électroniques sous forme de circuits monolithiques, des variantes peuvent être proposées dans lesquelles les fonctions qui ont été décrites en terme de comparaison de tensions sont transformées en fonctions équivalentes utilisant une comparaison de courants. Il est clair que de telles variantes restent dans le domaine de l'invention revendiquée ci-après.

**Revendications**

1. Circuit de commande de gain (10) d'un amplificateur pour l'écoute par haut-parleur dans un appareil comportant par ailleurs un microphone (1) et son amplificateur associé (5), notamment dans le but de supprimer l'effet Larsen, circuit consistant essentiellement en une boucle de contre-réaction réduisant le gain de l'amplificateur d'écoute (3) par haut-parleur lorsque le signal provenant du microphone dépasse un seuil prédéterminé caractérisé en ce que la boucle de contre-réaction comportant des premiers moyens de contrôle (100), commandant une réduction de gain de l'amplificateur d'écoute par haut parleur avec une première constante de temps, et le dit seuil prédéterminé étant un premier seuil (VR1), elle comporte encore des seconds moyens de contrôle comparant le signal provenant du microphone à un second seuil (VR2), plus faible que ledit premier seuil, qui commandent une réduction de gain avec une seconde constante de temps inférieure à la première, à partir du moment où le gain a été réduit en dessous d'une valeur de gain de référence par lesdits premiers moyens, alors qu'ils restent inactifs lorsque le gain reste supérieur à ladite valeur de référence.

2. Circuit de commande de gain selon la revendication 1 caractérisé en ce que le gain de l'amplificateur d'écoute par haut-parleur est commandé par la tension de charge (VC) d'un condensateur, chargé en permanence à travers une source de courant et en ce que les premiers et seconds moyens de contrôle ont leurs sorties qui provoquent la décharge de ce condensateur via respectivement une première (RD1) et une seconde résistance (RD2) de décharge, la première résistance de décharge ayant une valeur plus élevée que celle de la seconde résistance de décharge.

3. Circuit de commande de gain selon la revendication 2 caractérisé en ce que le condensateur est chargé à partir du potentiel le plus positif du circuit, en ce que lesdits premiers et seconds moyens de contrôle (100, 200) déchargent le condensateur par leur borne de sortie qui est du type à transistor NPN (ou MOS à canal N), à collecteur ouvert (ou drain ouvert), et en ce que la première résistance de décharge (RD1) du condensateur est disposée en série avec la seconde résistance (RD2) de décharge.

4. Circuit de commande de gain selon la revendication 1, caractérisé en ce que le gain de l'amplificateur d'écoute par haut-parleur est commandé par la tension de charge (VC) d'un condensateur, chargé en permanence à travers une source de courant, et en ce que les premiers et seconds moyens de contrôle (100, 200) provoquent la décharge de ce condensateur au moyen d'un courant dont la valeur est prédéterminée à la sortie de chacun de ces moyens de contrôle, le courant de sortie des premiers moyens étant fixé à une valeur plus faible que la valeur du courant de sortie des seconds moyens, et les sorties en question étant connectées en parallèle sur le condensateur.

5. Circuit de commande de gain selon la revendication 3 ou 4, caractérisé en ce que les premiers moyens de contrôle comportent un premier comparateur (101) dont l'entrée positive reçoit le signal (S') provenant du microphone après amplification, dont l'entrée négative est porté à une première tension de référence (VR1) laquelle étant inférieure au niveau continu du signal provenant du microphone, définit par rapport à ce niveau ledit premier seuil, et dont la sortie (VD) constitue la sortie desdits premiers moyens de contrôle, en ce que les seconds moyens de contrôle comportent un deuxième, un troisième et un quatrième comparateur (202, 203, 204), tous à sortie du type à collecteur ouvert d'un transistor NPN, en ce que le deuxième comparateur a son entrée négative qui reçoit le signal (S') provenant du microphone après amplification, et son entrée positive qui est portée à une deuxième tension de référence (VR2) légèrement supérieure à la première tension de référence mais cependant inférieure au niveau continu du signal provenant du microphone et qui définit par rapport à ce niveau ledit second seuil, en ce que la sortie du deuxième comparateur (202) est d'une part connectée au point intermédiaire d'un premier pont d'impédances lequel est connecté par ailleurs entre les tensions extrêmes du circuit et d'autre part connectée à l'entrée négative du troisième comparateur (203), en ce que le quatrième comparateur (204) reçoit sur son entrée positive une tension sensiblement égale à la tension de charge du condensateur et a son entrée négative portée à une troisième tension de référence correspondant à la tension présentée par le condensateur pour ladite valeur de gain de référence, en ce que la sortie du quatrième comparateur est connectée au pied d'un deuxième pont d'impédances connecté en tête à la tension la plus positive et dont le point intermédiaire est connecté à l'entrée négative du troisième comparateur et fait apparaître, lorsque la sortie du quatrième comparateur est à l'état bas, une quatrième tension de référence qui est réglée à une valeur inférieure à la tension du point intermédiaire du premier pont d'impédances lorsque la sortie du deuxième comparateur est dans l'état de haute impédance, et en ce que la sortie du troisième comparateur constitue la sortie desdits deuxièmes moyens de contrôle.

6. Application du circuit de commande selon l'une des revendications 1 à 5 à un poste téléphonique à écoute amplifiée par haut-parleur.

**Claims**

1. Gain control circuit (10) of a listening amplifier connected to a loudspeaker channel in an apparatus further including a microphone (1) and its associated amplifier (5), more specifically, with a view to suppressing the Larsen effect, the circuit essentially consisting of a negative feedback loop reducing the gain of the listening amplifier (3) connected to the loudspeaker channel when the signal coming from the microphone exceeds a predetermined threshold, characterized in that the negative feedback loop comprises a first control means (100) controlling a gain reduction of the listening amplifier connected to the loudspeaker channel with a first time constant, and said predetermined threshold being a first threshold (VR1), also includes a second control means comparing the signal coming from the microphone to a second threshold (VR2) lower than said first threshold, which second control means controls a gain reduction with a second time constant which is shorter than the first one, from the moment when the gain is reduced to below a reference gain value by said first control means, whereas they remain inactive when the gain remains higher than said reference value.

2. Gain control circuit as claimed in Claim 1, characterized in that the gain of the listening amplifier connected to the loudspeaker channel is controlled by the charge voltage (VC) of a capacitor permanently charged through a current source, and in that the first and second control means have outputs which cause this capacitor to be discharged *via* a respective first (RD1) and second discharge resistor (RD2), the first discharge resistor having a value which is higher than that of the second discharge resistor.

3. Gain control circuit as claimed in Claim 2, characterized in that the capacitor is charged from the most positive potential in the circuit, in that said first and second control means (100, 200) discharge the capacitor by their output terminal which is of the NPN transistor type (or N-channel MOS), with an open collector (or open drain), and in that the first discharge resistor (RD1) of the capacitor is arranged in series with the second discharge resistor (RD2).

4. Gain control circuit as claimed in Claim 1, characterized in that the gain of the listening amplifier connected to the loudspeaker channel is controlled by the charge voltage of a capacitor permanently charged *via* a current source, and in that the first and second control means (100, 200) cause the capacitor to be discharged by means of a current whose value is preset at the output of each of the control means, the output current of the first control means being fixed at a lower value than said value of the output current of the second control means, and in that the outputs are connected in parallel to the capacitor.

5. Gain control circuit as claimed in one of the Claims 3 or 4, characterized in that the first control means comprises a first comparator (101) whose positive input receives the signal (S) coming from the microphone after amplification, whose negative input is connected to a first reference voltage (VR1) which is lower than the DC level of the signal coming from the microphone, defined as said first threshold with respect to this level, and whose output (VD) constitutes the output of said first control means, in that the second control means comprises a second, a third and a fourth comparator (202, 203,204), all of them with an output of the NPN transistor type having an open collector, in that the second comparator has its negative input which receives the signal (S) coming from the microphone after amplification, and its positive input which is connected to a second reference voltage (VR2) which is slightly higher than the first reference voltage but lower than the DC level of the signal coming from the microphone and which defines said second threshold with respect to this level, in that the output of the second comparator (202) is connected on the one hand to the intermediate point of a first impedance bridge which is connected between the extreme voltages of the circuit and on the other hand to the negative input of the third comparator (203), in that the fourth comparator (204) receives at its positive input a voltage substantially equal to the charge voltage of the capacitor and has its negative input connected to a third reference voltage corresponding to the voltage presented by the capacitor for said reference gain value, in that the output of the fourth comparator is connected to the foot of a second impedance bridge whose head is connected to the most positive voltage supply and whose intermediate point is connected to the negative input of the third comparator and makes a fourth reference voltage appear when the output of the fourth comparator is in a low-impedance state, which fourth reference voltage is adjusted to a value which is lower than the voltage of the intermediate point of the first impedance bridge when the output of the second comparator is in the high-impedance state, and in that the output of the third comparator constitutes the output of said second control means.

6. The use of the control circuit as claimed in one of the Claims 1 to 5 in a loudspeaking telephone set.

**Patentansprüche**

1. Verstärkungsregelschaltung (10) eines Verstärkers zum Hören über einen Lautsprecher in einem Gerät, das außerdem ein Mikrophon (1) und einen zugeordneten Verstärker (5) aufweist, insbesondere zum Unterdrücken des Larsen-Effektes, wobei diese Schaltung im wesentlichen eine Gegenkopplungsschleife bildet, welche die Verstärkung des Verstärkers (3) zum Hören über den Lautsprecher verringert, wenn das von dem Mikrophon herrührende Signal eine vorbestimmte Schwelle überschreitet, dadurch gekennzeichnet, daß die Gegenkopplungsschleife, die erste Regelmittel (100) aufweist, die eine Verringerung der Verstärkung zum Hören über den Lautsprecher mit einer ersten Zeitkonstanten regeln und daß die genannte vorbestimmte Schwelle eine erste Schwelle (VR1) ist, und daß die Schleife außerdem zweite Regelmittel aufweist, die das Mikrophonsignal mit einer zweiten Schwelle (VR2) vergleichen, die niedriger ist als die genannte erste Schwelle, wobei diese Mittel eine Verringerung der Verstärkung mit einer gegenüber der ersten, niedrigeren zweiten Zeitkonstanten herbeiführen, ausgehend von dem Zeitpunkt, an dem die Verstärkung durch die genannten ersten Mittel bis unter einen Bezugsverstärkungswert zurückgebracht wird, während sie inaktiv bleiben, wenn die Verstärkung höher bleibt als der genannte Bezugswert.

2. Verstärkungsregelschaltung nach Anspruch 1, dadurch gekennzeichnet, daß die Verstärkung des Verstärkers zum Hören über den Lautsprecher durch die Ladespannung (VC) eines über eine Stromquelle konstant geladenen Kondensators gesteuert wird, und daß die ersten und zweiten Regelmittel mit ihrem die Entladung des Kondensators herbeiführenden Ausgang über einen ersten (RD1) bzw. einen zweiten Entladewiderstand (RD2) verbunden sind, wobei der erste Entladewiderstand einen Wert aufweist, der höher ist als der des zweiten Entladewiderstandes.

3. Verstärkungsregelschaltung nach Anspruch 2, dadurch gekennzeichnet, daß der Kondensator aus dem positivsten Potential der Schaltung aufgeladen wird, daß die genannten ersten und zweiten Regelmittel (100, 200) über ihren Ausgang, der vom Typ eines NPN-Transistors ist (oder vom N-Kanal MOS-Typ) mit offenem Kollektor (oder mit offener Drain), den Kondensator entladen, und daß der erste Entladewiderstand (RD1) des Kondensators mit dem zweiten Entladewiderstand (RD2) reihengeschaltet ist.

4. Verstärkungsregelschaltung nach Anspruch 1, dadurch gekennzeichnet, daß die Verstärkung des Verstärkers zum Hören über den Lautsprecher durch die Ladespannung (VC) eines Kondensators gesteuert wird, der über eine Stromquelle konstant aufgeladen wird, und daß die ersten und zweiten Regelmittel (100, 200) die Entladung dieses Kondensators mittels eines Stromes herbeiführen, dessen Wert an dem Ausgang jedes dieser Regelmittel vorbestimmt wird, wobei der Ausgangsstrom der ersten Mittel auf einen Wert festgesetzt wird, der niedriger ist als der Wert des Ausgangsstromes der zweiten Mittel, und wobei die betreffenden Ausgänge mit dem Kondensator parallelgeschaltet sind.

5. Verstärkungsregelschaltung nach Anspruch 3 oder 4, dadurch gekennzeichnet, daß die ersten Regelmittel eine erste Vergleichsschaltung (101) aufweisen, deren positiver Eingang das von dem Mikrophon herrührende, verstärkte Signal (5) erhält, deren negativer Eingang auf einer erste Bezugsspannung (VR1) gebracht wird, die niedriger ist als der kontinuierliche Pegel des Mikrophonsignals und die genannte erste Schwelle gegenüber diesem Pegel bestimmt, und deren Ausgang (VD) den Ausgang der genannten Regelmittel bildet, daß die zweiten Regelmittel eine zweite, eine dritte und eine vierte Vergleichsschaltung (202, 203, 204) aufweisen, alle mit einem Ausgang vom Typ eines NPN-Transistors mit offenem Kollektor, daß die zweite Vergleichsschaltung einen negativen Eingang aufweist, der das verstärkte Mikrophonsignal (5') erhält, und einen positiven Eingang, der auf eine zweite Bezugsspannung (VR2) gebracht wird, die etwas höher ist als die erste Bezugsspannung, aber niedriger als der kontinuierliche Pegel des Mikrophonsignals und gegenüber diesem Pegel die zweite Schwelle bestimmt, daß der Ausgang der zweiten Vergleichsschaltung (202) einerseits mit dem Mittenabgriff einer ersten Impedanzbrücke verbunden ist, die u.a. zwischen den äußersten Spannungen der Schaltung verbunden ist, und andererseits mit dem negativen Eingang der dritten Vergleichsschaltung (203) verbunden ist, daß die vierte Vergleichsschaltung (204) an dem positiven Eingang eine Spannung erhält, die der Ladespannung des Kondensators nahezu entspricht und an dem negativen Eingang, der auf eine dritte Bezugsspannung gebracht ist, die der Spannung entspricht, die durch den Kondensator für den genannten Bezugsverstärkungswert angeboten wird, daß der Ausgang der vierten Vergleichsschaltung mit dem Schenkel einer zweiten Impedanzbrücke verbunden ist, deren Kopf mit der positiveren Spannung verbunden ist, und deren Mittenabgriff mit dem negativen Eingang der dritten Vergleichsschaltung verbunden ist und eine vierte Bezugsspannung erscheinen läßt, wenn der Ausgang der vierten Vergleichsschaltung niedrig ist, wobei diese vierte Bezugsspannung auf einen Wert geregelt wird, der niedriger ist als die Spannung des Mittenabgriffs der ersten Impedanzbrücke, wenn der Ausgang der zweiten Vergleichsschaltung sich in dem Zustand hoher Impedanz befindet, und daß der Ausgang der dritten Vergleichsschaltung den Ausgang der genannten zweiten Regelmittel bildet.

6. Verwendung der Regelschaltung nach einem der Ansprüche 1 bis 5 bei einem lautsprechenden Fernsprechapparat.

FIG.1

FIG.3

FIG.2

EP 0 280 381 B1